# FASCICULE DE BREVET EUROPEEN

(11) **EP 2 574 552 B1**
(45) Date de publication et mention de la délivrance du brevet: **02.01.2019**
(21) Numéro de dépôt: 12186403.7
(22) Date de dépôt: 27.09.2012
(51) Int. Cl.: B64D 13/00, H05K 7/20

(54) **Système de ventilation et circuits de soufflage et d'extraction d'air d'un tel système, ainsi que baie avionique d'aéronef**
Lüftungssystem, Auslass- und Rückführverteiler eines solchen Systems sowie Avionikcompartment eines Flugzeugs
Ventilation system, air blowing and extraction circuits of such a system, as well as an aircraft avionics bay

(30) Priorité: 30.09.2011 FR 1158842
(43) Date de publication de la demande: 03.04.2013
(73) Titulaire: Airbus Opérations SAS, 31060 Toulouse (FR)
(72) Inventeur: Guerin, Bernard, 31850 MONTRABE (FR); Durand, Yves, 31840 AUSSONNE (FR)
(74) Mandataire: Gevers & Orès

(56) Documents cités:
- WO-A1-02/16854
- WO-A1-94/14308
- DE-A1- 10 333 353
- FR-A1- 2 900 308
- US-A- 4 153 225
- US-A- 4 819 720
- US-A- 5 253 484

## Description

### DOMAINE TECHNIQUE

L'invention se rapporte aux systèmes de ventilation d'une baie avionique d'un aéronef, en particulier aux circuits de soufflage et d'extraction d'air de ce système.

L'invention s'applique de manière générale aux aéronefs équipés d'une baie avionique qui regroupe du matériel électrique et électronique sous forme de meubles intégrant des coeurs électriques, des calculateurs et/ou d'autres équipements électroniques (convertisseurs, etc.), et/ou des modules annexes aux équipements électriques/électroniques tels que les modules de puissance, batteries, centrales inertielles, etc. Couplés à cette baie, des harnais électriques permettent de relier ce matériel aux appareils fonctionnels ou opérationnels concernés via le réseau de bord.

En fonctionnement, ce matériel dissipe de la chaleur. Le domaine de l'invention concerne le refroidissement continu de ce matériel par transfert de la chaleur dissipée. Dans le présent texte, l'expression « baie avionique » n'est pas limitée aux avions mais peut s'appliquer à tout type d'aéronef ou autre moyen de transport comportant une cabine de pilotage.

### ÉTAT DE LA TECHNIQUE

Jusqu'à présent, la baie avionique est agencée dans la soute située sous la structure de plancher du cockpit et en partie dans la soute cargo disposée sous la cabine passagers. L'expression « baie avionique » désigne dans le présent texte l'ensemble des meubles électriques et électroniques visés ci-dessus. Le document US 4 153 225 décrit une baie avionique agencé dans la soute cargo d'un aéronef.

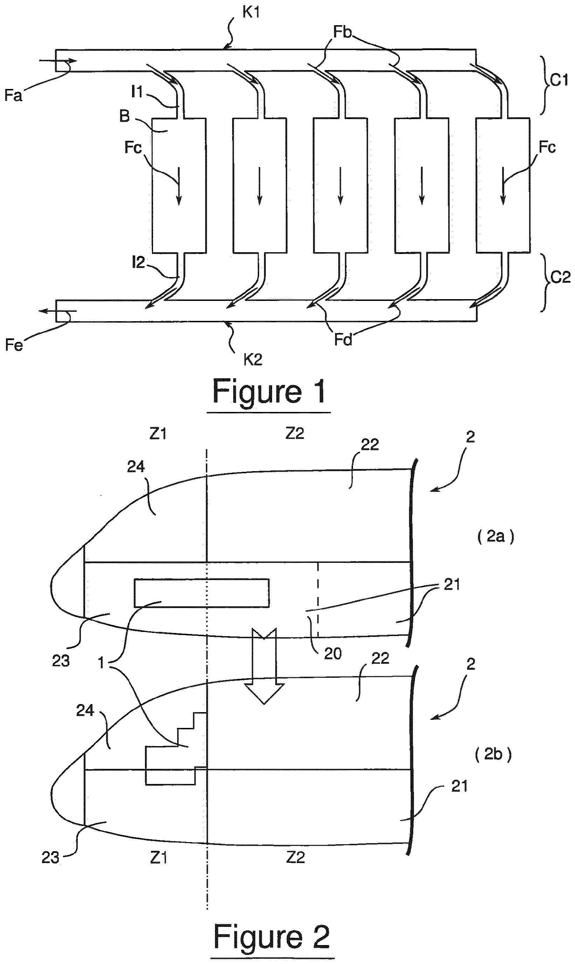

A l'heure actuelle, du fait de l'augmentation des équipements électriques, le refroidissement de la baie avionique est réalisé, comme illustré schématiquement en figure 1, par un ensemble de deux circuits indépendants comportant : un circuit de soufflage C1 composé d'une canalisation K1 d'entrée de soufflage d'air (flèche Fa) dans chaque meuble B par couplage avec des canaux individuels I1 (flèches Fb), l'air circulant ensuite dans chaque meuble (flèche Fc), et un circuit d'extraction C2 de l'air ayant traversé les meubles B composé de canaux individuels I2 d'extraction d'air (flèches Fd) couplés à une canalisation K2 d'extraction de sortie (flèche Fe). Il existe un circuit de soufflage C1 et un circuit d'extraction C2 pour chacun des côtés de l'avion. Ces circuits sont doublés pour des raisons de sécurité.

Ces circuits posent des problèmes en termes d'installation, par la complexité de leur forme du fait du faible volume disponible, De plus, dans la soute cargo, l'intégration du matériel électrique/électronique est également problématique du fait que cette zone n'est pas sécurisée. La séparation à respecter entre les systèmes redondants (meubles, routes électriques, circuits d'air, etc.) est contraignante.

Il a donc été proposé d'intégrer l'ensemble de la fonction de baie avionique dans la zone sécurisée en avant de l'aéronef, comportant le cockpit, la soute cargo avant et la structure de plancher entre eux.

Cependant, le problème de l'encombrement se pose alors de manière aiguë puisque cette zone sécurisée avant, en particulier le cockpit, est déjà bien remplie par tout son équipement et ses appareillages. Les moyens de soufflage et d'extraction habituels, constitués de tubes de fort diamètre connectés les uns aux autres, sont maintenant constitués en matériau composite de faible épaisseur pouvant être « travaillé » pour une meilleure intégration. Néanmoins, ces moyens présentent des contraintes d'installation difficiles à gérer du fait de leur complexité et de leur volume, ainsi que par la fragilité de leur constitution en matériau léger et mince (en général en matériau composite).

### EXPOSÉ DE L'INVENTION

L'invention vise à s'affranchir de ces contraintes d'installation par une approche multifonctionnelle des pièces opérationnelles de la baie avionique et des pièces de structure d'un plancher, sensiblement dans leur volume initial. De plus, l'invention a pour but de réaliser des gains de masse et de coût, en diminuant le nombre de pièces et en réalisant une intégration du système.

L'invention s'applique en particulier à la structure de plancher d'un cockpit d'aéronef qui est un espace sécurisé privilégié, le volume structural du plancher séparant alors le cockpit de la soute de pointe avant. Le plancher d'autres zones de l'aéronef peut également être utilisé, en particulier celui de zones de passage dédiées (cuisine, toilettes, etc.) à l'avant, à l'arrière et parfois en partie centrale de la cabine passager.

Plus précisément, un objet de la présente invention est un système de ventilation de baie électronique intégrée dans un aéronef comprenant au moins un meuble, le système comprenant un circuit de soufflage et un circuit d'extraction. Dans ce système, le circuit de soufflage comporte au moins un caisson intégré dans un plancher destiné à l'aéronef et des moyens de distribution d'air entre le(s) meuble(s) et le(s) caisson(s). Et le circuit d'extraction comporte au moins un conduit de transmission d'air intégré à au moins un meuble

Selon un système de ventilation plus particulier, le circuit de soufflage comporte ledit au moins un caisson intégré dans le plancher destiné à l'aéronef et lesdits moyens de distribution d'air, et le circuit d'extraction comporte ledit au moins un conduit de transmission d'air.

L'invention a également pour objet un circuit de soufflage d'une baie avionique, intégrée dans un aéronef et comprenant au moins un meuble. Ce circuit du système de ventilation particulier ci-dessus, comporte au moins un caisson de rigidification d'un plancher. Le circuit comporte également des moyens de distribution de l'air de soufflage dans le(s)dit(s) meubles de la baie à partir de ce ou ces caisson(s).

Selon des particularités avantageuses, le circuit comporte un double caisson, chaque caisson étant disposé symétriquement par rapport à l'autre selon un plan de symétrie longitudinal. Chaque caisson comporte des parois transversales, une paroi supérieure et une paroi inférieure, au moins une paroi transversale possède des moyens de connexion à des moyens de transmission d'air frais. De plus, dans au moins une paroi latérale, dans sa paroi supérieure formant un couvercle et/ou dans sa paroi inférieure, chaque caisson peut être muni d'orifices de distribution d'air aptes à canaliser des flux de soufflage d'air pour ventiler les meubles avioniques disposés au plus près.

Selon des modes de réalisation préférés :
- des tubulures de liaison relient au moins un orifice de chaque caisson aux moyens de transmission d'air frais ;
- des cloisons intérieures à chaque caisson, formées parallèlement à la face de connexion aux moyens de transmission d'air frais, possèdent également des orifices alignés sur ceux de la paroi de connexion ;
- les orifices de distribution d'air sont munis de diaphragmes ajustables aptes à réaliser une jonction étanche et une régulation des flux de soufflage ;
- la paroi inférieure de chaque caisson est inclinée de sorte que le caisson présente une section évolutive afin d'assurer un drainage des eaux de condensation de l'air de ventilation ;
- des ouvertures sont réalisées dans les cloisons de chaque caisson pour assurer la circulation de l'eau drainée ;
- une résine d'étanchéité est déposée sur chaque caisson afin d'en augmenter l'étanchéité.

Selon l'invention, un circuit d'extraction d'air d'une baie avionique intégrée dans un aéronef comprenant au moins un meuble peut être constitué par le circuit de soufflage ci-dessus. Dans un tel circuit d'extraction d'air, le sens des flux d'air est inversé de sorte que ces flux d'air inversés, les moyens de distribution d'air et/ou les moyens de transmission d'air sont dédiés à l'extraction.

L'invention se rapporte également à un circuit d'extraction d'une baie avionique intégrée dans un aéronef comprend au moins un meuble, en particulier un cockpit d'aéronef. Ce circuit d'extraction du système de ventilation particulier défini plus haut, comporte des conduits de transmission intégrés aux meubles et dédiés à la transmission d'air inter meubles de sorte à réaliser une configuration globale de compacité maximisée.

Selon certains modes de réalisation préférés :
- des manchons combinés à des pièces de liaison réalisent les jonctions étanches du circuit d'extraction ;
- les meubles à ventiler étant formés par de caissons composés de parois, des conduits parallélépipédiques de transmission d'air sont formés sur au moins une paroi sensiblement horizontale et/ou verticale des meubles pour épouser au moins partiellement cette paroi ; ces conduits constituent des espaces d'extraction intégrés aux meubles dans lesquels les flux d'air circulent après avoir réalisé un échange thermique dans le meuble ;
- les meubles constituent en partie supérieure des collecteurs d'extraction vers le conduit de transmission d'air ou un manchon de raccordement.

Selon l'invention, un circuit de soufflage d'une baie avionique intégrée dans un aéronef comprenant au moins un meuble peut également être constitué par le circuit d'extraction ci-dessus. Dans ce circuit de soufflage dans lequel le sens des flux d'air est inversé de sorte que les conduits de transmission d'air intégrés aux meubles, les flux d'air et/ou les collecteurs sont dédiés au soufflage.

L'invention se rapporte également à un système de ventilation du type défini ci-dessus avec un circuit de soufflage constitué par le circuit d'extraction défini ci-dessus dans lequel le sens des flux d'air est inversé de sorte que les conduits de transmission d'air intégrés aux meubles, les flux d'air et/ou les collecteurs sont dédiés au soufflage. Dans ce système, le circuit d'extraction est constitué par le circuit défini ci-dessus dans lequel le sens des flux d'air est également inversé de sorte que ces flux d'air, les moyens de distribution d'air et/ou les moyens de transmission d'air sont dédiés à l'extraction.

L'invention se rapporte également à une baie avionique comportant des meubles et intégrant un circuit de transmission d'air, pouvant servir de circuit d'extraction et de circuit de soufflage du système de ventilation ci-dessus. Ce circuit de transmission comporte des conduits de transmission d'air intégrés aux meubles et dédiés à la transmission d'air inter meubles de sorte à réaliser une configuration globale de compacité maximisée. Les meubles sont alors disposés au plus près les uns des autres de sorte que les conduits et les manchons inter-meubles présentent un encombrement minimal.

### PRÉSENTATION DES FIGURES

D'autres données, caractéristiques et avantages de la présente invention apparaîtront à la lecture de la description non limitée qui suit, en référence aux figures annexées qui représentent, respectivement :
- la figure 1, un schéma de ventilation de meubles par un ensemble de circuits et de canalisations selon l'état de la technique (déjà commenté) ;
- la figure 2, deux schémas de principe montrant la position de la baie avionique avant (schéma 2a) et après (schéma 2b) son intégration dans la zone sécurisée ;
- la figure 3, une vue perspective simplifiée d'une architecture de cockpit d'aéronef intégrant des caissons latéraux de soufflage ;
- la figure 4, une vue perspective d'une baie avionique équipée de moyens de soufflage et d'extraction selon l'invention ;
- les figures 5a à 5c, des vues perspective (figures 5a et 5b) et en coupe (figure 5c) d'un exemple de caisson de soufflage selon l'invention, et
- la figure 6, une vue schématique en coupe des meubles d'une baie avionique intégrant des moyens d'extraction selon l'invention.

### DESCRIPTION DÉTAILLÉE

Dans le présent texte, les qualificatifs « avant », arrière », « dessous », « supérieur », « inférieur », « latéral », « transversal », « intérieur », « extérieur », « vertical », horizontal », et leurs dérivés ou équivalents, se rapportent à des positionnements relatifs d'éléments dans une configuration standard d'un avion reposant sur le sol et par rapport à un plan de symétrie longitudinal vertical dans cette configuration.

En référence au schéma de principe de la figure 2, l'installation de la baie avionique 1 dans un avion 2 est classiquement distribuée (schéma 2a) entre une partie 20 de la zone cargo 21 - située sous la cabine passagers 22 dans une zone non sécurisée Z2 - et la soute avant 23 située sous le cockpit 24 dans une zone sécurisée Z1. Selon l'invention (schéma 2b), la baie avionique 1 est partiellement déplacée pour venir totalement dans la zone sécurisée Z1 en avant de l'avion 2, par une répartition de la baie entre la soute avant 23 et le cockpit 24. De préférence, la baie avionique est très majoritairement installée dans le cockpit - par exemple à 80% et plus - comme illustré ci-dessous.

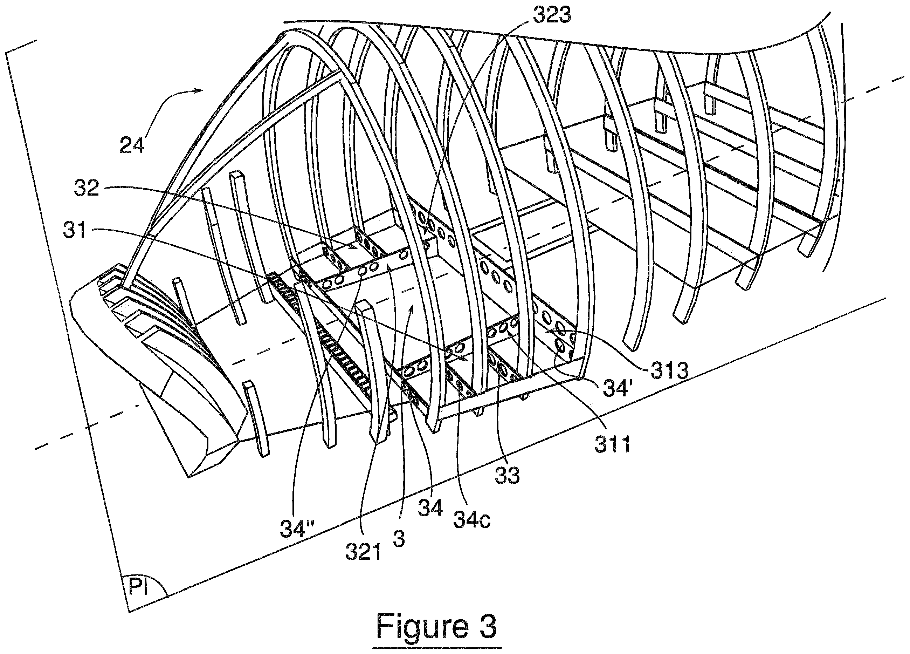

La vue simplifiée d'une architecture de cockpit 24 de la figure 3 montre les caissons latéraux 31 et 32 par lesquels l'air frais transite avant de souffler dans la baie avionique. Ces caissons 31 et 32 sont disposés symétriquement par rapport au plan de symétrie longitudinal Pl et laissent libre un volume central 3 qui pourra accueillir un meuble de la baie avionique (voir la description détaillée ci-dessous).

Les caissons 31 et 32 possèdent des cloisons internes 33 transversales. Ces cloisons 33, les parois longitudinales intérieures 311 et 321 respectivement des caissons 31 et 32, ainsi que les parois transversales arrière 313 et 323 de ces caissons, sont percées d'orifices, respectivement d'orifices 34c, 34, 34' et 34" afin de réaliser un soufflage d'air. Ces cloisons 33 et les parois 311, 321, 313 et 323 sont verticales.

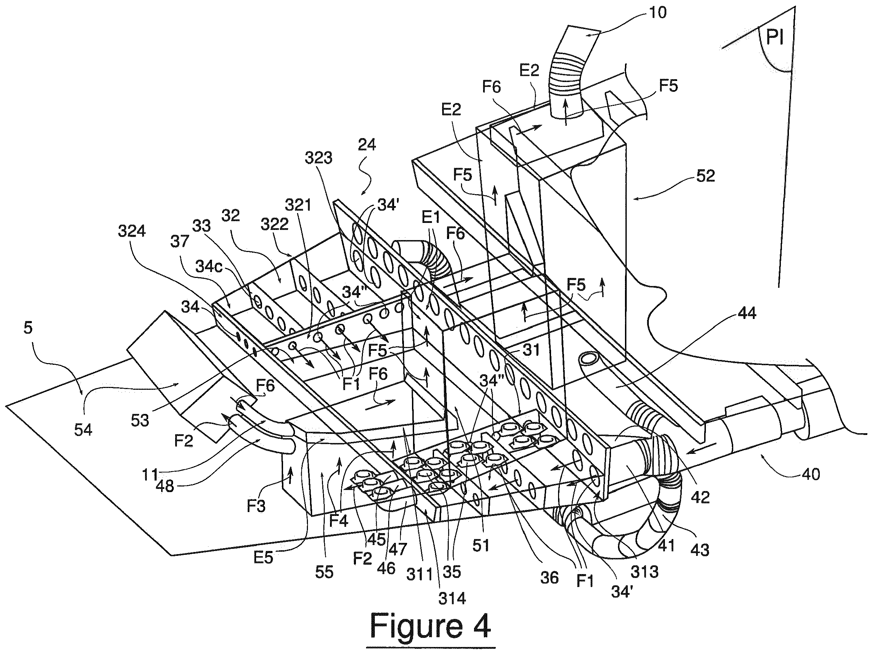

En référence à la figure 4, les moyens de soufflage et d'extraction d'une baie avionique composée de meubles 51 à 55 (représentés en transparence pour une plus grande visibilité de la figure), sont illustrés partiellement afin de ne pas surcharger la figure. Ces meubles sont disposés dans le cockpit 24 de manière aussi compacte que possible, afin de les rapprocher au maximum pour définir des conduits d'extraction bien intégrés, de compacité ainsi maximisée, et gagner de l'espace par ailleurs. Ainsi, dans l'exemple illustré, les meubles 55, 51 et 52 sont disposés de manière sensiblement juxtaposés, du moins haut au plus élevé en allant de l'avant à l'arrière du cockpit 24. Le meuble 54 est décalé de manière centrée dans le cockpit et incliné sur le plancher 5 du cockpit. Le meuble 53 est disposé dans le volume central 3 libéré dans le plancher de marche 5 du cockpit. D'autres meubles équivalents, non représentés, peuvent être disposés symétriquement par rapport au plan longitudinal Pl.

L'air frais de soufflage provient de tubulures étanches de distribution d'air 41 à 44 issues d'un tube principal 40. Les tubulures 41 à 43 sont connectées aux orifices 34' d'entrée d'air dans les caissons 31 et 32. L'air traverse ensuite les meubles 51 à 55, est soumis à des échanges thermiques lors de ces traversées pour extraire les calories présentes, puis est évacué des meubles via un tube d'extraction 10.

Comme illustré en référence au caisson 31, l'air soufflé (flèches F1) qui pénètre dans ce caisson est redirigé vers les meubles 51 à 55 de la baie avionique, soit directement - à travers des orifices 34" et 35 formées respectivement dans les parois longitudinales internes 311, 321 et dans des couvercles horizontaux 36 et 37 des caissons pour les meubles 53 et 51 -, soit à travers les orifices 34 des parois transversales avant 314, 324 des caissons, en connexion avec des manchons 45 à 48. Les manchons 45 à 47 relient le caisson 31 au meuble 55, et le manchon 48 relie les meubles 55 et 54 afin d'assurer le soufflage d'air dans ces meubles (flèches horizontales F2 et verticale F3). Les parois longitudinales externes 312 et 322 des caissons 31 et 32 sont constituées par des portions du fuselage qui ferme ainsi les caissons.

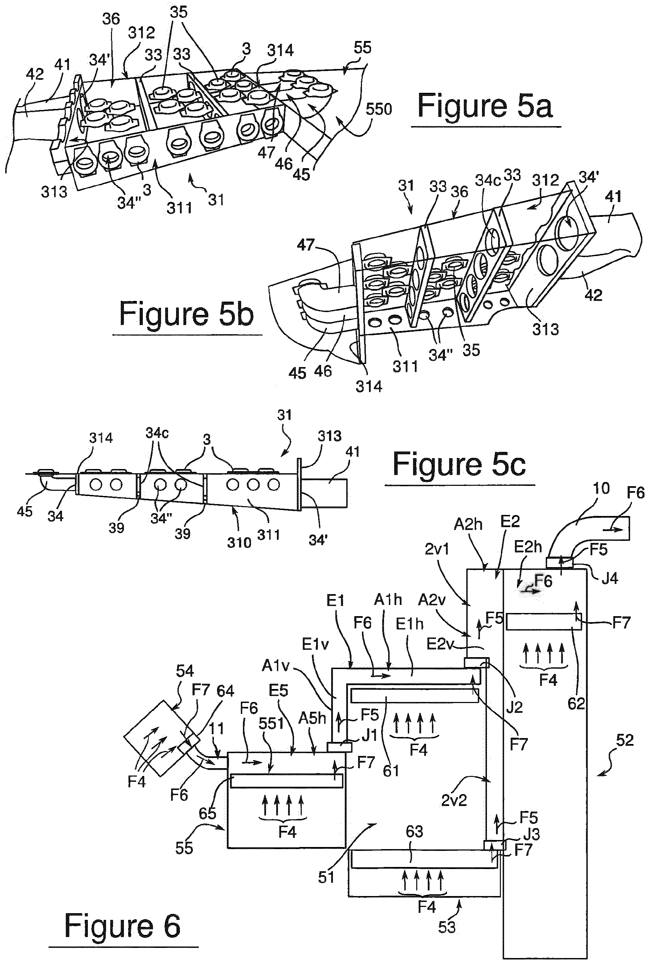

Le caisson 31 est illustré plus précisément en référence aux figures 5a à 5c, par des vues en perspective (latérale en figure 5a et par en-dessous en figure 5b) et en coupe (figure 5c).

Sur ces figures 5a à 5c, apparaissent les tubulures de distribution d'air frais 41 et 42, les manchons de transfert d'air frais 45 à 47, les orifices de passage d'air horizontaux 35 formés dans le couvercle 36 et verticaux 34, 34', 34", 34c formés respectivement dans les parois transversales avant 314, arrière 313, dans la paroi longitudinale intérieure 311, et dans les cloisons 33. Les orifices de distribution d'air 34, 34', 34", et 35 sont équipés de diaphragmes d'étanchéité 3 ajustables pour permettre de réguler le flux d'air. La paroi longitudinale externe 312 ne présente pas d'orifice de passage d'air.

Les manchons de transfert 45 à 47 sont également connectés via des diaphragmes ajustables 3 aux orifices 35 formés dans la paroi de fond 550 du meuble 55 partiellement représenté.

La vue en coupe selon la figure 5c met en évidence la section décroissante du caisson 31 dans son extension longitudinale. La paroi de fond 310 de ce caisson est incliné de sorte que les parois transversales 313 et 314 présentent une hauteur juste supérieure au diamètre des orifices 34 et 34', le diamètre des orifices 34' étant sensiblement supérieur à celui des orifices 34.

Cette configuration inclinée des caissons permet un drainage des eaux de condensation issues de l'air de ventilation. Des ouvertures très fines 39 sont réalisées dans les cloisons pour assurer la circulation de l'eau drainée. De plus, l'inclinaison des caissons est réglée pour ajuster leur hauteur en fonction du besoin en ventilation.

Par ailleurs, l'air frais soufflé dans les meubles 51 à 55 est extrait de ces meubles, comme illustré par la vue perspective de la figure 4 et la vue en coupe de la figure 6. Le circuit d'extraction est constitué par des manchons de raccordement 11 entre les meubles, ici entre les meubles 54 et 55, par des conduits de circulation d'air adjacentes, ici E1, E2, E5, intégrées aux meubles 51, 52 et 55, et par le tube 10 d'extraction finale d'air hors du cockpit.

Les conduits de circulation adjacents E5, E1 et E2 limitent chacun un espace d'extraction parallélépipédique, par deux parois principales parallèles dont l'une est constituée par une paroi formant au moins en partie une paroi du meuble, ici des meubles 51, 52 et 55.

En particulier, le conduit d'extraction E5 est limité par un parallélépipède rectangle dont la paroi principale A5h est parallèle à la paroi supérieure horizontale 551 du meuble 55. Les conduits d'extraction E1 et E2 définissent globalement deux demi-espaces «perpendiculaires» entre eux E1v et E1h, E2v et E2h. Les demi-espaces de chaque espace d'extraction « perpendiculaires » sont perpendiculaires car limitées par des parois perpendiculaires, respectivement A1v et A1h ou A2v et A2h.

De plus, chaque paroi d'espace d'extraction peut être constituée de plusieurs parois parallèles pour s'adapter à l'architecture des meubles : par exemple, la paroi A2v est constituée des parois 2v1 et 2v2 afin d'extraire l'air provenant non seulement de l'espace E1 mais également de du caisson 53.

En outre, des joints étanches inter-meubles J1 à J3 et de liaison J4 entre l'espace d'extraction E2 et le tube d'extraction finale 10 sont agencés pour connecter les conduits d'extraction, respectivement E5 et E1, E1 et E2 ainsi que E3 et E2, et former un circuit d'extraction continu.

Du fait que l'air chaud monte, le positionnement successif des espaces d'extraction est horizontal et/ou vertical ascendant. L'extraction d'air se fait alors en suivant des trajectoires verticales ascendantes selon les flèches F4 dans les meubles 51 à 55, ainsi que selon des trajectoires verticales ascendantes (flèches F5) et horizontales (flèches F6) dans les espaces d'extraction, à savoir : manchon d'extraction horizontale 11 du meuble 54, dans le conduit d'extraction horizontal E5 du meuble 55, dans le demi-espace d'extraction vertical E1v et le demi-espace horizontal A1h du meuble 51, ainsi que dans le demi-espace vertical A2v et le demi-espace horizontal E2h du meuble 52.

La partie supérieure des meubles 51 à 55 constituent des collecteurs d'extraction 61 à 65 (flèches F7) d'air chaud en liaison avec les espaces d'extraction adjacents : le manchon de raccordement 11 pour le meuble 54, l'espace E5 pour le meuble 55, le demi-espace E2v pour le meuble 53 et les demi-espaces E1h et E2h pour les meubles 51 et 52.

L'invention n'est pas limitée aux exemples de réalisation décrits et représentés. Ainsi, Les caissons 31 et 32 peuvent également faire office de plancher de marche 5 du cockpit 24. De plus ces caissons peuvent également contribuer majoritairement au refroidissement d'autres équipements et appareillages du cockpit par des ouvertures réalisées sur leur paroi supérieure ou sur leur paroi inférieure pour le refroidissement de matériel situé dans la partie inférieure (soute avant ou cargo).

Par ailleurs, chaque meuble peut intégrer plus deux espaces d'extraction, par exemple sur chaque face externe (c'est-à-dire au plus six espaces pour un meuble parallélépipédique). En outre, les espaces d'extraction peuvent être réalisés à l'intérieur du meuble (première catégorie) ou à l'extérieur du meuble initial (deuxième catégorie). Dans ce dernier cas, le meuble final intègre les espaces d'extraction. Dans l'exemple de réalisation illustré plus haut, le meuble 55 appartient à la première catégorie et les meubles 51 et 52 à la deuxième.

De plus, les circuits de soufflage et d'extraction et les moyens qui les composent peuvent être inversés dans leur fonction par inversion du sens des flux d'air : le soufflage peut être opéré « par le haut » à partir de l'extracteur qui sert alors de fournisseur d'air frais et les espaces d'extraction deviennent des espaces de soufflage, alors que l'extraction est réalisée « par le bas » et l'évacuation de l'air chaud réalisée par les tubulures de fourniture d'air.

## Revendications

1. Aéronef comprenant un système de ventilation de baie électronique (1) intégrée dans l'aéronef, la baie électronique comprenant au moins un meuble (51 à 55), l'aéronef présentant un cockpit, le système de ventilation comprenant un circuit de soufflage et un circuit d'extraction, le circuit d'extraction comportant des manchons de raccordement (11) disposés entre les meubles, au moins un conduit de transmission d'air (E1, E2, E5) intégré à au moins un meuble (51 à 55), et un tube (10) d'extraction finale d'air hors du cockpit, le ou les conduits de transmission d'air (E1, E2, E3) limitant chacun un espace d'extraction parallélépipédique par deux parois principales parallèles dont l'une est constituée par une paroi formant au moins en partie une paroi du ou des meubles (51 à 55), le circuit de soufflage comportant au moins un caisson (31, 32) intégré dans un plancher (5) de l'aéronef et des moyens de distribution d'air (33, 34, 34', 35, 45 à 48) disposés entre le(s) meuble(s) (51 à 55) et le(s) caisson(s) (31, 32), le ou les caissons (31, 32) faisant office de plancher de marche du cockpit de l'aéronef.

2. Aéronef selon la revendication 1, **caractérisé en ce que** le circuit de soufflage comporte au moins un caisson (31, 32) de rigidification d'un plancher (5) et des moyens de distribution (33, 34, 34', 35, 45 à 48) de l'air de soufflage configuré pour souffler de l'air dans au moins un meuble (51 à 55) de la baie (1) à partir de ce(s) caisson(s) (31, 32).

3. Aéronef selon la revendication 2, **caractérisé en ce que** le circuit de soufflage comporte un double caisson (31, 32), chaque caisson (31, 32) étant disposé symétriquement par rapport à l'autre selon un plan de symétrie longitudinal (PI) et comportant des parois transversales (313, 314), une paroi supérieure (36, 37) et une paroi inférieure (310), et **en ce qu'**au moins une paroi transversale (313) possède des moyens de connexion (34) à des moyens de transmission d'air frais (41 à 43).

4. Aéronef selon la revendication précédente, **caractérisé en ce que** chaque caisson (31, 32) est muni, sur au moins une paroi transversale (313, 314) et sur sa paroi supérieure formant un couvercle (36, 37), d'orifices (34, 34', 35) aptes à canaliser des flux de soufflage d'air (F1 à F3) pour ventiler les meubles avioniques (51 à 55) disposés au plus près.

5. Aéronef selon la revendication précédente, dans lequel des tubulures de liaison (41 à 43) relient au moins un orifice (34') de chaque caisson (31, 32) aux moyens de transmission d'air frais (40, 41 à 43).

6. Aéronef selon l'une quelconque des revendications 3 à 5, dans lequel des cloisons intérieures (33) à chaque caisson (31, 32), formées parallèlement à la paroi de connexion (313, 314) aux moyens de transmission d'air frais (40, 41 à 43), possèdent également des orifices (34) alignés sur ceux de la paroi de connexion (313, 314).

7. Aéronef selon l'une quelconque des revendications 4 à 6, dans lequel les orifices de distribution d'air (34, 34', 35) sont munis de diaphragmes ajustables (3) aptes à réaliser une jonction étanche et une régulation des flux de soufflage d'air (F1 à F3).

8. Aéronef selon l'une quelconque des revendications 4 à 7, dans lequel la paroi inférieure (310) de chaque caisson (31, 32) est inclinée de sorte que le caisson présente une section évolutive afin d'assurer un drainage des eaux de condensation de l'air de ventilation.

9. Aéronef selon la revendication précédente, dans lequel des ouvertures (39) sont réalisées dans les cloisons (33) de chaque caisson (31, 32) pour assurer la circulation de l'eau drainée.

10. Aéronef selon l'une quelconque des revendications 4 à 9, dans lequel une résine d'étanchéité est déposée sur les parois (310, 311, 312, 313, 314, 36 ; 321, 322, 37) de chaque caisson (31 ; 32) afin d'en augmenter l'étanchéité.

11. Aéronef selon la revendication 4, **caractérisé en ce que** le circuit d'extraction comprend au moins des moyen de distribution d'air (33, 34, 34', 35, 45 à 48) et des moyens de transmission d'air (41 à 43) configurés pour l'extraction.

12. Aéronef selon la revendication 11, **caractérisé en ce que** le circuit de soufflage comprend des meubles (51 à 55) et des conduits de transmission d'air (E1, E2, E5) intégrés aux meubles (51, 52, 55) et dédiés à la transmission d'air inter meubles, les meubles (51 à 55) étant formés par des caissons composés de parois (A5h, A1v, A1h, A2v, A2h), des conduits parallélépipédiques de transmission d'air (E1, E2, E5) sont formés sur au moins une paroi sensiblement horizontal (A5h, A1h, A2h) et/ou verticale (A1v, A2v) des meubles (51, 52) pour épouser au moins partiellement cette paroi (A5h, A1v, A1h, A2v, A2h) et constituer des espaces intégrés aux meubles (51, 52, 55).

13. Aéronef selon la revendication précédente, dans lequel des manchons (11) combinés à des pièces de liaison (J1 à J3) réalisent des jonctions étanches.

14. Aéronef selon les revendications 12 ou 13, dans lequel les meubles (51 à 55) constituent en partie supérieure des collecteurs (61 à 65) vers le conduit de transmission d'air (E1, E2, E5) ou un manchon de raccordement (11).

## Patentansprüche

1. Flugzeug, umfassend ein in das Flugzeug integriertes Elektronikcompartment-Lüftungssystem (1), wobei das Elektronikcompartment mindestens ein Möbelstück (51 bis 55) umfasst, wobei das Flugzeug ein Cockpit aufweist, das Lüftungssystem einen Auslassverteiler und einen Rückführverteiler umfasst, wobei der Rückführverteiler Anschlusshülsen (11), die zwischen den Möbelstücken angeordnet sind, mindestens einen Luftübertragungskanal (E1, E2, E5), der in mindestens ein Möbelstück (51 bis 55) integriert ist, und ein Rohr (10) zur endgültigen Rückführung von Luft aus dem Cockpit beinhaltet, wobei der Luftübertragungskanal bzw. die Luftübertragungskanäle (E1, E2, E3) jeweils einen quaderförmigen Rückführraum durch zwei parallele Hauptwände begrenzen, von denen eine durch eine Wand gebildet ist, die zumindest teilweise eine Wand des Möbelstücks bzw. der Möbelstücke (51 bis 55) bildet, wobei der Auslassverteiler mindestens einen Kasten (31, 32), integriert in einen Boden (5) des Flugzeugs und Luftverbreitungsmittel (33, 34, 34', 35, 45 bis 48) beinhaltet, die zwischen dem/den Möbelstück(en) (51 bis 55) und dem/den Kasten bzw. Kästen (31, 32) angeordnet sind, wobei der/die Kasten bzw. Kästen (31, 32) als Gehboden des Flugzeugcockpits fungiert bzw. fungieren.

2. Flugzeug nach Anspruch 1, **dadurch gekennzeichnet, dass** der Auslassverteiler mindestens einen Kasten (31, 32) zum Versteifen eines Bodens (5) und Mittel zum Verbreiten (33, 34, 34', 35, 45 bis 48) der Auslassluft beinhaltet, die zum Auslassen der Luft in mindestens ein Möbelstück (51 bis 55) des Compartements (1) aus diesem/diesen Kasten bzw. Kästen (31, 32) konfiguriert ist.

3. Flugzeug nach Anspruch 2, **dadurch gekennzeichnet, dass** der Auslassverteiler einen Doppelkasten (31, 32) beinhaltet, wobei jeder Kasten (31, 32) symmetrisch zu einem anderen in einer Längssymmetrieebene (PI) angeordnet ist und Querwände (313, 314), eine obere Wand (36, 37) und eine untere Wand (310), beinhaltet, und dadurch, dass mindestens eine Querwand (313) Verbindungsmittel (34) mit Frischluftübertragungsmitteln (41 bis 43) besitzt.

4. Flugzeug nach dem vorstehenden Anspruch, **dadurch gekennzeichnet, dass** jeder Kasten (31, 32) an mindestens einer Querwand (313, 314) und an seiner eine Abdeckung (36, 37) bildenden oberen Wand mit Öffnungen (34, 34', 35) versehen ist, die geeignet sind, Luftauslassströme (F1 bis F3) zu kanalisieren, um die so nah wie möglich angeordneten Avionikmöbelstücke (51 bis 55) zu belüften.

5. Flugzeug nach dem vorstehenden Anspruch, wobei Verbindungsstutzen (41 bis 43) mindestens eine Öffnung (34') jedes Kastens (31, 32) mit den Frischluftübertragungsmitteln (40, 41 bis 43) verbinden.

6. Flugzeug nach einem der Ansprüche 3 bis 5, wobei innere Trennwände (33) an jedem Kasten (31, 32), die parallel zur Verbindungswand (313, 314) zu den Frischluftübertragungsmitteln (40, 41 bis 43) ausgebildet sind, ebenfalls Öffnungen (34) besitzen, die mit jenen der Verbindungswand (313, 314) ausgerichtet sind.

7. Flugzeug nach einem der Ansprüche 4 bis 6, wobei die Luftverbreitungsöffnungen (34, 34', 35) mit anpassbaren Membranen (3) versehen sind, die imstande sind, eine dichte Verbindung und eine Regelung der Luftauslassströme (F1 bis F3) zu realisieren.

8. Flugzeug nach einem der Ansprüche 4 bis 7, wobei die untere Wand (310) jedes Kastens (31, 32) derart geneigt ist, dass der Kasten einen sich entwickelnden Querschnitt aufweist, um für eine Drainage von Kondenswasser aus der Lüftungsluft zu sorgen.

9. Flugzeug nach dem vorstehenden Anspruch, wobei in den Trennwänden (33) jedes Kastens (31, 32) Öffnungen (39) realisiert sind, um für die Zirkulation von drainiertem Wasser zu sorgen.

10. Flugzeug nach einem der Ansprüche 4 bis 9, wobei ein Dichtungsharz auf die Wände (310, 311, 312, 313, 314, 36; 321, 322, 37) jedes Kastens (31; 32) aufgebracht ist, um die Dichtung zu erhöhen.

11. Flugzeug nach Anspruch 4, **dadurch gekennzeichnet, dass** der Rückführverteiler mindestens Luftverbreitungsmittel (33, 34, 34', 35, 45 bis 48) und Luftübertragungsmittel (41 bis 43) umfasst, die zum Auslassen konfiguriert sind.

12. Flugzeug nach Anspruch 11, **dadurch gekennzeichnet, dass** der Auslassverteiler Möbelstücke (51 bis 55) und Luftübertragungskanäle (E1, E2, E5) umfasst, die in die Möbelstücke (51, 52, 55) integriert und für die Luftübertragung zwischen Möbelstücken vorgesehen sind, wobei die Möbelstücke (51 bis 55) durch Kästen ausgebildet sind, die aus Wänden (A5h, A1v, A1h, A2v, A2h) bestehen, quaderförmige Luftübertragungskanäle (E1, E2, E5) an mindestens einer im Wesentlichen horizontalen (A5h, A1h, A2h) und/oder vertikalen (A1v, A2v) Wand der Möbelstücke (51, 52) gebildet sind, um sich diese Wand (A5h, A1v, A1h, A2v, A2h) zumindest teilweise anzupassen und in die Möbelstücke (51, 52, 55) integrierte Räume zu bilden.

13. Flugzeug nach dem vorstehenden Anspruch, wobei Hülsen (11), die mit Verbindungsteilen (J1 bis J3) kombiniert sind, dichte Nahtstellen realisieren.

14. Flugzeug nach den Ansprüchen 12 oder 13, wobei die Möbelstücke (51 bis 55) am oberen Abschnitt Sammler (61 bis 65) zum Luftübertragungskanal (E1, E2, E5) oder eine Anschlusshülse (11) bildet.

## Claims

1. Aircraft comprising a ventilation system for an electronic bay (1) integrated into the aircraft, the electronic bay (1) comprising at least one cabinet (51 to 55), the aircraft having a cockpit, the ventilation system comprising a blowing circuit and an extraction circuit, the extraction circuit comprising connection sleeves (11) arranged between the cabinets, at least one air transmission conduct (E1, E2, E5) integrated into at least one cabinet (51 to 55), and a final air extraction tube (10) outside the cockpit, the air transmission conduct(s) (E1, E2, E5) each limiting a parallelepiped extraction space by two parallel main walls, one of which consists in a wall forming at least in part a wall of the cabinet(s) (51 to 55), the blowing circuit comprising at least one strut assembly (31, 32) integrated into a floor (5) of the aircraft and air distribution means (33, 34, 34', 35, 45 to 48) arranged between the cabinet(s) (51 to 55) and the strut assembly or assemblies (31, 32), the strut assembly or assemblies (31, 32) serving as a walking floor of the cockpit of the aircraft.

2. Aircraft according to claim 1,
**characterized in that** the blowing circuit comprises at least one floor (5) stiffening strut assembly (31, 32) and distribution means (33, 34, 34', 35, 45 to 48) for air blowing configured for blowing air in at least one cabinet (51 to 55) of the bay (1) from such strut assembly or assemblies (31, 32).

3. Aircraft according to claim 2,
**characterized in that** the blowing circuit comprises a double strut assembly (31, 32), each strut assembly (31, 32) being symmetrically arranged with respect to each other according to a longitudinal plane of symmetry (PI) and comprising traversal walls (313, 314), an upper wall (36, 37) and a lower wall (310), and **in that** at least one transversal wall (313) possesses connecting means (34) with fresh air transmission means (41 to 43).

4. Aircraft according to the preceding claim,
**characterized in that** each strut assembly (31, 32) is provided, on at least one transversal wall (313, 314) and on its lid-forming upper wall (36, 37), with orifices (34, 34', 35) being adapted to channel air blowing flows (F1 to f3) so as to ventilate the avionics cabinets (51 to 55) being arranged the closest.

5. Aircraft according to the preceding claim,
wherein connection manifolds (41 to 43) connect at least one orifice (34') of each strut assembly (31, 32) to the fresh air transmission means (40, 41 to 43).

6. Aircraft according to any of claims 3 to 5,
wherein partitions (33) internal to each strut assembly (31, 32), formed in parallel with the connection wall (313, 314) to the fresh air transmission means (40, 41 to 43), also possess orifices (34) aligned with these of the connection wall (313, 314).

7. Aircraft according to any of claims 4 to 6,
wherein the air distribution orifices (34, 34', 35) are provided with adjustable diaphragms (3) adapted to make a sealing junction and a regulation of the air blowing flows (F1 to F3).

8. Aircraft according to any of claims 4 to 7,
wherein the lower wall (310) of each strut assembly (31, 32) is tilted so that the strut assembly presents an evolutionary section in order to provide a drainage of the condensation waters from the ventilation air.

9. Aircraft according to the preceding claim,
wherein openings (39) are arranged in the partitions (33) of each strut assembly (31, 32) so as to provide the circulation of drained water.

10. The blowing circuit according to any of claims 4 to 9,
wherein a sealing resin is deposited on the walls (310, 311, 312, 313, 314, 36 ; 321, 322, 37) of each strut assembly (31 ; 32) so as to increase sealing.

11. Aircraft according to claim 4,
**characterized in that** the extraction circuit comprises at least air distribution means (33, 34, 34', 35, 45 to 48) and air transmission means (41 to 43) dedicated to the extraction.

12. Aircraft according to claim 11,
**characterized in that** the blowing circuit comprises cabinets (51 to 55) and air transmission conducts (E1, E2, E5) integrated into the cabinets (51, 52, 55) and dedicated to the inter-cabinets air transmission, the cabinets (51 to 55) being formed by strut assemblies composed of walls (A5h, A1v, A1h, A2h, A2v), air transmission parallelepiped conducts (E1, E2, E5) are formed on at least one substantially horizontal (A5h, A1h, A2h) and/or vertical (A1v, A2v) wall of the cabinets (51, 52) in order to at least partially meet such wall (A5h, A1v, A1h, A2v, A2h), and provide spaces integrated into the cabinets (51, 52, 55).

13. Aircraft according to the preceding claim,
wherein sleeves (11) combined with connection parts (J1 to J3) make sealing junction.

14. Aircraft according to claims 12 or 13,
wherein the cabinets (51 to 55) constitute in the top part of the collectors (61 to 65) towards the air transmission conduct (E1, E2, E5) or a connection sleeve (11).
